# EUROPEAN PATENT APPLICATION

(11) **EP 0 918 322 A1**
(43) Date of publication of application: **26.05.1999**
(21) Application number: 98907188.1
(22) Date of filing: 12.03.1998
(51) Int. Cl.: G11B 7/135

(54) **LASER BEAM GENERATING CIRCUIT USING SEMICONDUCTOR LASER DEVICE**

(30) Priority: 13.03.1997 JP 82191/97; 12.08.1997 JP 230299/97; 28.08.1997 JP 247650/97; 28.08.1997 JP 247651/97
(71) Applicant: TOYO COMMUNICATION EQUIPMENT CO. LTD., Kouza-gun, Kanagawa 253-0192 (JP)
(72) Inventor: ISHIKAWA, Masayuki, Toyo Communic. Equipmt Co.Ltd, Kouza-gun, Kanagawa 253-0192 (JP); SATOH, Tomio, Toyo Communic. Equipmt CO., Ltd, Kouza-gun, Kanagawa 253-0192 (JP); HASEGAWA, Shin, Toyo Communic. Equipmt Co., Ltd, Kouza-gun, Kanagawa 253-0192 (JP)
(74) Representative: Skone James, Robert Edmund
(86) International application number: JP9801030
(87) International publication number: WO9840882

(57) **Abstract**

So as to provide a high-frequency oscillator which sufficiently satisfies standards for unnecessary radiation and to obtain a high-frequency oscillator in which the matching capacitance is definitively determined and the oscillation level of the oscillator is lowered so that unnecessary radiation is reduced, an inductor element L5 which has a high impedance at the frequency used is inserted into the ground line of a high-frequency oscillator CT1 which drives a semiconductor laser LD1, so that the ground line of the oscillator and the other ground line are isolated from each other in high-frequency terms. In addition, inductor elements L5 through L7 are also inserted into the power supply terminal Vcc of a high-frequency oscillator CT1, the power supply terminal LDD of a semiconductor laser LD1 and the terminal PD used to check the amount of beam emitted by the semiconductor laser; and these inductor elements are constructed from ferrite beads FB2 through FB5. The ferrite beads FB2 through FB5 are formed as integrated ferrite bead arrays. Furthermore, a laser beam generating device is constructed so as to be driven by superimposing high-frequency currents of at least two frequencies close to the semiconductor laser LD1 on a direct current.

## Description

### Technical Field

The present invention relates to a laser beam generating circuit, and more particularly to a laser beam generating circuit equipped with a high-frequency oscillating circuit which is used to superimpose a high-frequency signal on a direct current used to drive a semiconductor laser device.

### Background Technology

In recent years, high-density memory data recording media that uses laser beam (optical disks) such as DDS (digital video disks), MOs (magneto-optic disks), PDs (phase change rewritable disks), etc. have been utilized in large quantities. Optical pick-up devices which are used to write information on such optical disks or to read out information written thereon are constructed from semiconductor laser devices (laser beam oscillating elements) and optical system devices.

For example, in cases where read-out is performed by an optical pick-up device, a laser beam emitted from a semiconductor laser device is directed via optical system lenses so that the laser beam is conducted to a storage position on the surface of the optical disk, and information recorded on the optical disk is read out by detecting the reflected beam with a detector as disclosed in Japanese Patent Application Publication (Kokoku) No. S59-9086.

When such read-out is performed, it is known that fluctuations in the beam output of the semiconductor laser caused by the incidence of reflected beam from the optical disk on the semiconductor laser device can be suppressed by superimposing a high-frequency current on the direct current that drives the semiconductor laser device.

Furthermore, in the high-frequency generating device which is used to generate a high-frequency current that is superimposed on the direct current used to drive the semiconductor laser device, the countermeasures taken against unnecessary radiation which occurs during the generation of the high frequency is one of the important design conditions that must be resolved in designing equipment such as the optical pick-up device, etc. For example, such countermeasures against unnecessary radiation includes, for instance, sealing off the high-frequency generating component inside the apparatus with a metal case.

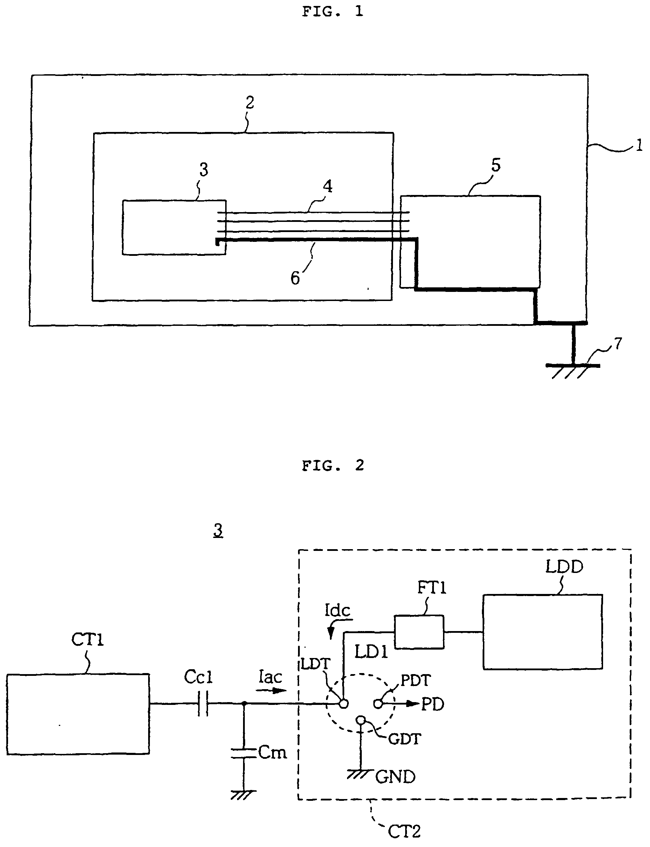

Figure 1 is a block diagram illustrating one example of such a laser beam generating circuit.

As shown in Figure 1, the optical pick-up device 2 comprises a high-frequency oscillator 3, a semiconductor laser (not shown), a flexible printed circuit board (FPC) 4, etc. and is connected to a control circuit 5 by means of the flexible printed circuit board 4. The ground line 6 of the optical pick-up device 2 is connected to the ground on the casing of the optical disk device 1 via a ground line inside the control circuit 5 and is thus grounded 7.

The high-frequency current for driving the semiconductor laser is generated by the high-frequency oscillator 3 of the optical pick-up device 2 shown in Figure 1; accordingly, the FPC 4 acts in the manner of a transmitting antenna and thus generates unnecessary radiation.

Figure 2 is a block diagram which illustrates a conventional construction of the high-frequency oscillator 3 in the laser beam generating circuit shown in Figure 1.

As shown in Figure 2, an LD driving current generated by a DC power source LDD inside the laser driving circuit CT2 is converted by a low-pass filter FT1 into a direct current Idc from which high-frequency noise has been removed, and this current Idc is supplied to the laser driving terminal LDT of a laser device LD1.

A high-frequency current generated by a high-frequency oscillating circuit CT1 passes through a coupling capacitance Cc1 and is impedance-matched by a matching capacitance Cm1 which is connected in parallel between itself and the ground; and the resulting current is then supplied to the laser driving terminal LDT of the semiconductor laser device LD1 as a high-frequency current Iac.

The coupling capacitance Cc1 also acts to superimpose the high-frequency current generated by the high-frequency oscillating circuit CT1 on the direct current supplied from the DC power source LDD. Since the semiconductor laser device LD1 performs an action that is equivalent to an electrical inductance, the matching capacitance Cm1 is set so as to resonate in parallel with the semiconductor laser device.

The low-pass filter FT1 of the laser driving circuit CT2 shown by the broken line is arranged so that the high-frequency current from the high-frequency oscillating circuit CT1 is prevented from flowing into the DC power source LDD; in addition, the impedance on the side of the DC power source LDD a seen from the coupling capacitance Cc1 is increased by the low-pass filter FT1 to a high value, so that there is no effect on the side of the laser drying circuit CT2.

The ground terminal GDT of the semiconductor laser device LD1 is grounded, and a photo-detection terminal PD which checks the amount of beam emitted is connected to a laser beam control circuit.

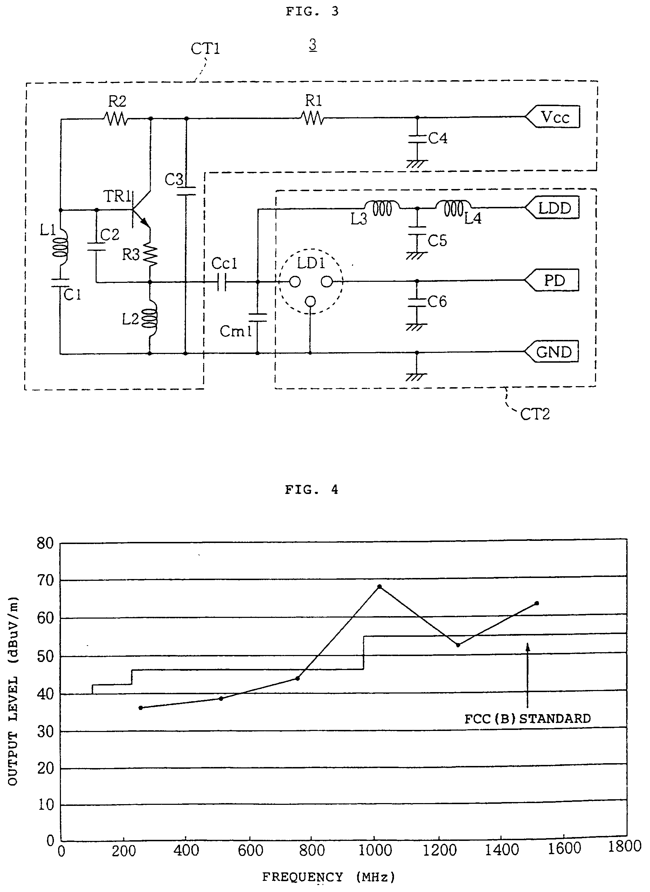

Figure 3 is a circuit diagram which illustrates conventional internal circuitry of the high-frequency oscillator 3 in the laser beam generating circuit shown in Figures 1 and 2.

The circuit shown in Figure 3 comprises the high-frequency oscillating circuit CT1 shown by a broken line and the laser driving circuit CT2 which is likewise shown by a broken line as well as a coupling capacitance Cc1, a matching capacitance Cm1, etc. Electric power is supplied to the high-frequency oscillating circuit CT1 from a power supply Vcc; and the power supply line from the power supply Vcc and the line from the photo-detection terminal to the laser beam control circuit have relatively large capacitances C4 and C6 located between these lines and the ground. Furthermore, inductances L3 and L4 and a capacitance C5 which constitute the low-pass filter FT1 as described above are inserted into the line that runs from the DC power source LDD to the semiconductor laser device LD1.

In figure 3, a DC voltage is applied to the collector of the transistor TR1 from the DC power supply Vcc via a resistance R1; and a resistance R2 used for a self-biased voltage is connected between the collector and the base.

A series circuit consisting of an inductance L1 and capacitance C1 which are the main elements that determine the oscillation frequency is connected to the base of the transistor TR1, and the other end of this circuit is connected to ground (GND). Furthermore, a series circuit consisting of a resistance R3 and an inductance L2 is connected between the emitter and ground, and a capacitance C2 used for feedback is connected between the base and emitter via the resistance R3.

One end of the coupling capacitance Cc1 is connected to an intermediate point between the resistance R3 and the inductance L2, and the other end thereof is connected to one of the terminals of the semiconductor laser device LD1 as an oscillating output terminal. The capacitance Cm1 is connected between the oscillating output terminal and the ground. A capacitance C3 used as a high-frequency by-pass capacitor is connected in parallel between the collected of the transistor Tr1 and the ground.

As described above, the semiconductor laser LD1 is driven by a direct current supplied from the semiconductor laser driving power source LDD (terminal); and at the same time, a high-frequency current from the high-frequency oscillator CT1 is superimposed on the direct current via the capacitance C3. A photo-detection (PD) terminal for checking the amount of beam emitted by the semiconductor laser LD1 is connected to an external control part; and in this case, the amount of beam emitted by the semiconductor laser LD1 is controlled by a circuit (not shown).

Meanwhile, the semiconductor laser LD1 has a low impedance in electrical terms and has the characteristics of an inductance in equivalent terms. Accordingly, a circuit employed is constructed so that the capacitance Cm1 and inductance L2 are connected in parallel with the semiconductor laser LD1, so that a parallel resonance is created (including the capacitance Cc1), thus supplying the maximum output current of the high-frequency oscillator to the semiconductor laser LD1.

Furthermore, a capacitance C4, a low-pass filter consisting of inductances L3, L4 and a capacitance C5, and a capacitance C6, are respectively inserted between the DC power supply Vcc (terminal) and the resistance R1, between the semiconductor laser driving power source LDD (terminal) and the terminal of the semiconductor laser LD1, and between the photo-detection (PD) terminal and the terminal of the semiconductor laser LD1; and these elements are grounded to the ground terminal (GND).

Furthermore, the high-frequency oscillating circuit CT1 shown by a broken line is an oscillating circuit known as a so-called "Colpitts" type circuit which is comprised of the transistor TR1, inductances L1 and L2, capacitances C1 and C2 and resistances R1, R2 and R3. If the synthesized capacitance of the capacitance C2 and the resistance R3 connected in series between the base and emitter of the transistor TR1 is designated as C22', and the impedance of the circuit formed by connecting the series circuit consisting of the coupling capacitance Cc1 and the matching capacitance Cm1 to the inductance L2 in parallel is designated as L22', then the oscillation frequency is determined by the element values of the oscillating loop formed by C1, L1, C22' and L22'.

As seen from above, the output frequency of the laser beam generating circuit shown in Figure 3 depends on the values of the elements that make up the oscillating loop, i. e., the inductance L1, capacitance C1, capacitance C2, inductance L2, coupling capacitance Cc1 and matching capacitance Cm1. By varying these element values, the frequency of the laser beam generating circuit can be changed. In particular, the element values of the inductance L1 and capacitance C1 of the series circuit are the governing factors in this case.

As described above, the low-pass filter connected to the DC power source LDD within the laser driving circuit CT2 indicated by a broken line is constructed from the inductances L3 and L4 and capacitance C5. This prevents the high-frequency current Iac supplied from the high-frequency oscillating circuit CT1 from flowing into the DC power source LDD. In addition, it is designed so that the impedance on the side of the DC power source LDD as seen from the capacitance Cc1 is increased to a high value, thus preventing any effect on the laser driving circuit CT2 side.

In the above-described high-frequency oscillator 3, the elements that radiate unnecessary electromagnetic waves are, mainly, the power supply line (Vcc) which supplies power to the high-frequency oscillating circuit CT1, the laser driving line (LDD) connected to the DC power source, the photo-detection line (PD) for checking the amount of beam emitted, and the ground line (GND).

As a conventional means of reducing the amount of unnecessary radiation as shown in Figure 3, the unnecessary high-frequency current is caused to flow to the ground side by inserting large-capacitance by-pass capacitors C4 and C6, etc. between the power supply Vcc and ground GND, or such unnecessary radiation is suppressed by inserting L3, L4 and C5 which constitute a low-pass filter.

To describe one example of a prototype laser beam generating circuit that uses the circuit construction shown in Figure 3, a 2SC4184 was used as the transistor TR1, the resistance R1 was set at 100 Ω, the resistance R2 was set at 10 k Ω, the resistance R3 was set at 15 Ω, the capacitance C1 was set at 27 pF, the capacitance C2 was set at 22 pF, the capacitance C3 was set at 330 P, the capacitance Cc1 was set at 15 pF, the capacitance Cm1 was set at 56 pF, the inductance L1 was set at 33 nH, and the inductance L2 was set at 39 nH. Furthermore, as element values used to prevent unnecessary radiation, the inductances L3 and L4 were set at 27 nH, the capacitance C4 was set at 30 pF, the capacitance C5 was set at 1000 pF, and the capacitance C6 was set at 330 pF, etc.

However, even in the high-frequency oscillator 3 equipped with the above-described by-pass capacitors C4 and C6 used to prevent unnecessary radiation, it frequently happens that the standards set, for example, by the FCC (U.S. Federal Communications Commission) cannot be satisfied, as indicated by the example of measured unnecessary radiation shown in Figure 4, and considerable adjustment work is required in order to adjust the unnecessary radiation characteristics to values that satisfy such standards. Alternatively, it may be necessary to provide shielding by means of a metal case.

Figure 4 shows one example of the frequency of a laser beam generating circuit that uses the above-described element values shown in Figure 3 plotted against the electric field intensity (dB µV/m) (output level) of the unnecessary radiated waves.

The oscillation frequency of the laser beam generating device shown in Figure 3 is in the range of 260 MHz to 300 MHz. As is clear from Figure 4, the measured value of the electric field intensity exceeds the FCC (B) standard (step-form regulatory value) for unnecesary radiation in the range from 800 MHz to 1200 MHz, and the standard is not satisfied.

However, in order to output the prescribed quantity of laser beam, the output of the high-frequency signal of the laser beam generating circuit must be increased to a large value. Accordingly, the power must be set at the very limit of the radiation standard.

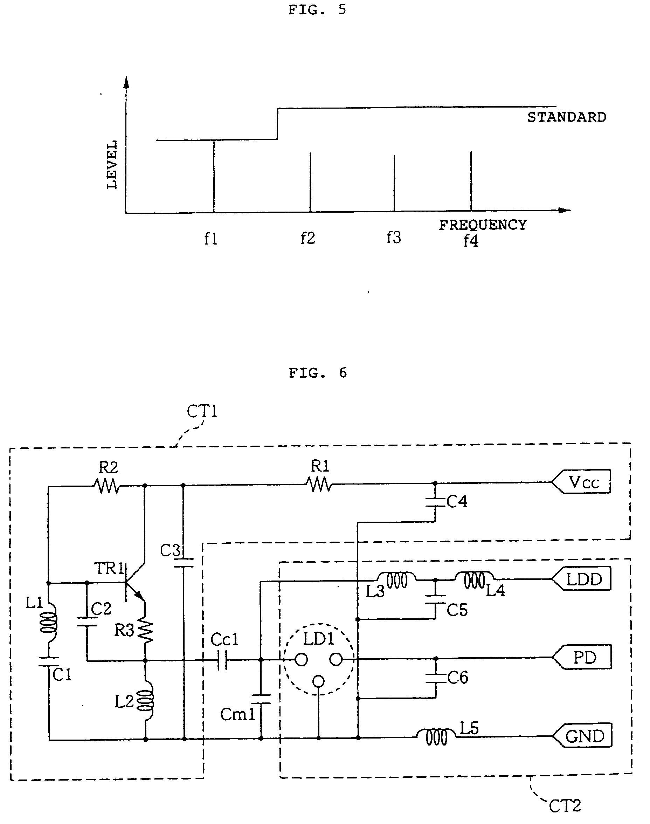

Figure 5 shows the relationship between the frequency components generated by the above-described high-frequency oscillating parts and the standard for unnecessary radiation in model form. As seen from Figure 5, a fundamental wave component (f1) and numerous higher harmonic components such as a second harmonic (f2) and third harmonic (f3), etc., are generated.

Meanwhile, a portion of the output of the high-frequency oscillating circuit CT1 generally leaks to the outside; however, as shown in Figure 4, the standard for unnecessary radiation is set for the levels (peak values) of the respective frequency components.

In actual manufacture, as shown in Figures 4 and 5, if the fundamental wave component is set at the very limit of the radiation standard, the radiation standard will often be exceeded at the frequencies of the higher harmonic components, etc. as a result of individual differences between laser beam generating circuits.

Furthermore, in the conventional circuit shown in Figure 3, the higher harmonic components are blocked by inserting an LC low-pass filter constructed from inductances and a capacitance into the circuit of the laser driving power source LDD. In this case, however, it is difficult to achieve sufficient suppression of unnecessary radiation, and considerable effort must be expended in making various adjustments of the element values of the laser beam generating circuit in order to satisfy the standard. Furthermore, in cases where an attempt is made to block higher harmonic components by inserting an LC low-pass filter constructed from inductances and a capacitance into the circuit of the power supply Vcc in the same manner as described above, it is also difficult to achieve sufficient suppression of unnecessary radiation, and considerable effort must still be expended in making various adjustments of the element values of the laser beam generating circuit in order to satisfy the standard. Conventionally, furthermore, the adjustments performed in order to obtain the optimal value or prescribed value of the superimposition effect as described above have been trial-and-error adjustments of the value of the matching capacitance Cm1; accordingly, these adjustments require considerable effort, resulting in increased costs.

### Disclosure of the Invention

The object of the present invention is to provide a laser beam generating circuit in which the above-described unnecessary radiation is reduced. More specifically, the object of the present invention is to provide a laser beam generating circuit in which unnecessary radiation is reduced by constructing the laser beam generating circuit so that sufficient stability of the amount of laser beam emitted can be obtained even if the level of the high-frequency signal that is superimposed on the laser driving DC power supply is reduced to a small value, and also to provide a laser beam generating circuit in which unnecessary radiation is minimized so that the unnecessary radiation sufficiently satisfies, for example, FCC standards, using the minimum required number of parts (e. g., without a shielding case) and without any need for a complicated adjustment process.

The various constructions and methods described below are used in the present invention in order to achieve the above object:
(1) In the high-frequency oscillator for driving the semiconductor laser, an inductor which shows a high impedance in the vicinity of the oscillation frequency of the high-frequency oscillator is inserted into the ground line of such a high-frequency oscillator.
(2) In addition to (1) described above, inductors which show a high impedance in the vicinity of the oscillation frequency of the same high-frequency oscillator are further inserted in the power supply line (Vcc) which supplies power to the high-frequency oscillating circuit CT1, in the laser driving line (LDD) which is connected to the DC current source, and in the photo-detection line (PD) which is used to check the amount of laser beam emitted.
(3) In addition to (2) described above, ferrite beads are used as inductors which show the high impedance in the vicinity of the oscillation frequency of the high-frequency oscillator.
(4) Ferrite beads are used instead of the tank circuit used in the feedback circuit of the high-frequency oscillating circuit.
(5) The matching capacitance of the semiconductor laser and high-frequency oscillating circuit is inserted so that the capacitance matches the oscillation frequency of the high-frequency oscillator, thus making it possible to obtain the desired superimposition effect by an adjustment performed in a short time.
(6) The high frequency that is superimposed on the laser driving line is arranged so that the high frequency includes not only a fundamental wave, but also higher harmonics such as second and third harmonies, etc., or a plurality of fundamental wave oscillating circuits are used, so that multiple frequencies consisting of two or more frequencies can be superimposed.

### Brief Explanation of the Figures

Figure 1 illustrates the internal construction of a beam pick-up device.
Figure 2 is a block diagram which illustrates one example of a conventional laser beam generating circuit.
Figure 3 is a circuit diagram which illustrates one example of a conventional laser beam generating circuit.
Figure 4 is a graph which shows the relationship between the measurement frequency and measured values of unnecessary radiation in one example of a conventional laser beam generating circuit and a standard for unnecessary radiation.
Figure 5 is a diagram which shows, in model form, the relationship between frequency spectrum data for the fundamental wave and higher harmonics in one example of a laser beam generating circuit and a standard for unnecessary radiation.
Figure 6 is a circuit diagram which illustrates one embodiment of the laser beam generating circuit according to the present invention.
Figure 7 is a graph which shows the relationship between the measurement frequency and measured values of unnecessary radiation in one embodiment of the laser beam generating circuit of the present invention and a standard for unnecessary radiation.
Figure 8 is a circuit diagram which illustrates one embodiment of the laser beam generating circuit according to the present invention.
Figure 9 is a circuit diagram which illustrates one embodiment of the laser beam generating circuit according to the present invention.
Figure 10 is a diagram which illustrates one embodiment of the laser beam generating circuit according to the present invention.
Figure 11 is a graph showing typical characteristics of ferrite beads.
Figures 12(a) through 12(c) are perspective views which show the structure of a ferrite bead array and a completed block.
Figure 13 is a circuit diagram which illustrates one embodiment of the laser beam generating circuit according to the present invention.
Figure 14 is a diagram which shows, in model form, the relationship between frequency spectrum data for the fundamental wave and higher harmonics in one embodiment of the laser beam generating circuit of the present invention and a standard for unnecessary radiation.
Figure 15 is a diagram which shows the frequency spectrum of one embodiment of the laser beam generating circuit according to the present invention.
Figure 16 is a diagram which illustrates the superimposition effect from the relationship between the driving current of the laser beam generating circuit and the beam output of the semiconductor laser.
Figure 17 is a graph which illustrates the relationship of the semiconductor laser mode, frequency of the superimposed current and matching capacitance in a case where the high-frequency oscillation frequency is 250 MHz.
Figure 18 is a graph which illustrates the relationship of the semiconductor laser mode, frequency of the superimposed current and matching capacitance in a case where the high-frequency oscillation frequency is 350 MHz.

### Best Mode to Carry Out the Invention

In order to describe the invention of the present application in greater detail, a description will be presented on the basis of preferred embodiments illustrated in the accompanying drawings.

Figure 6 is a circuit diagram which illustrates one embodiment of the laser beam generating circuit of the present invention.

The laser beam generating circuit of the embodiment shown in Figure 6 differs as follows from the conventional laser beam generating circuit shown in Figure 3: i. e., an inductor L5 is inserted into the ground line of this laser beam generating circuit so that the ground of the high-frequency oscillating circuit CT1 and the ground of the control device (PD, etc.) are isolated in the high-frequency region, thus preventing the emission of unnecessary radiation. It is desirable that this inductor L5 be constructed using ferrite beads as will be described later.

The embodiment shown in Figure 6 is based on the experience of the inventors of the present invention in the design of portable wireless sets, etc.

In designing portable wireless sets, etc., it is known that the radiation of electromagnetic waves occurs if there is a sufficient line length or a sufficient conductive pattern area for electric current to generate a magnetic field.

However, the circuit parts of a high-frequency oscillator used for lasers are sufficiently small (5 mm x 5 mm), and it is considered that there would be almost no radiation from the circuit parts.

Accordingly, considering that unnecessary radiation from a high-frequency oscillator used for lasers occurs as a result of the extension of a long ground line from the high-frequency oscillator, the inventor inferred that the unnecessary radiation can be reduced by isolating the ground line from the grounding line.

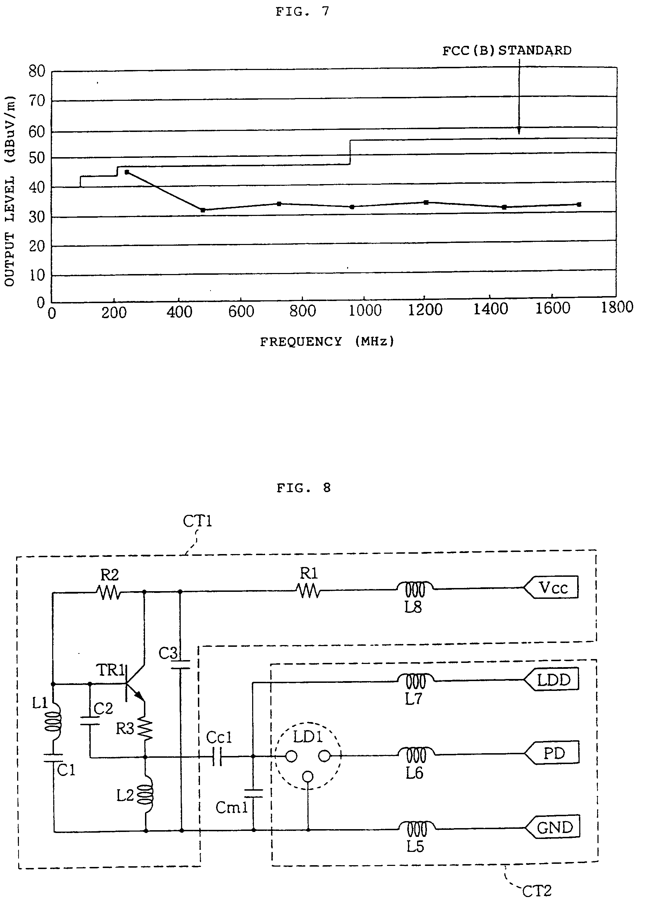

One example of the measurement of unnecessary radiation in a prototype laser high-frequency oscillator constructed on the basis of the above-described approach is shown in Figure 7. Figure 7 is a graph which shows the relationship between the measurement frequency and measured values of unnecessary radiation in one embodiment of the laser beam generating circuit of the present invention, and a standard for unnecessary radiation.

In Figures 6 and 7, the oscillation frequency of the prototype high-frequency oscillating circuit CT1 is 300 MHz, and the impedance of the inductor inserted into the ground line is approximately 500 ohms at 300 MHz.

As is clear from Figure 7, it is ascertained that the FCC standard is sufficiently satisfied in a state without any shielding case.

Figure 8 is a circuit diagram which illustrates an embodiment of the laser beam generating circuit of the present invention in which inductors L6 through L8 used for the purpose of cutting off the connection with the high-frequency oscillating circuit CT1 in the high-frequency region are respectively inserted between the DC power supply Vcc (terminal) and the resistance R1, between the semiconductor laser driving power source LDD (terminal) and the terminal of the semiconductor laser LD1, and between the photo-detection (PD) terminal and the terminal of the semiconductor laser LD1, in the same manner as the inductor L5 inserted into the ground line in Figure 7, thus preventing the emission of unnecessary radiation. It is desirable that these inductors L6 through L8 also be constructed using, as will be described later, ferrite beads, etc. in the same manner as the inductor L5.

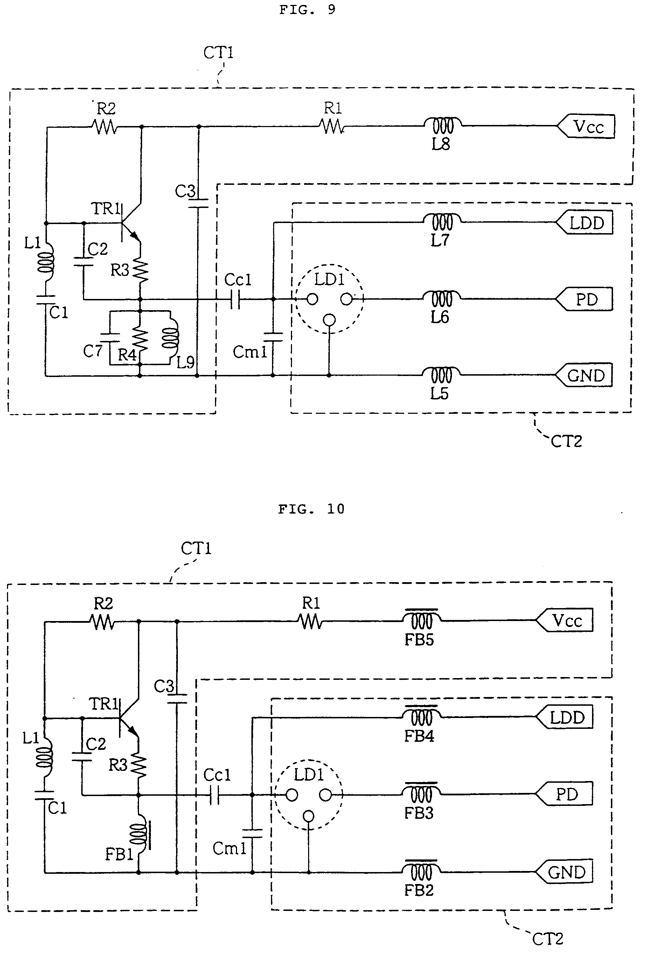

Figure 9 is a circuit diagram which illustrates an embodiment of the laser beam generating circuit of the present invention in which a tank circuit consisting of a capacitance C7, a resistance R4 and an inductor L9 is inserted instead of the inductor L2 in the high-frequency oscillating circuit CT1 of the circuit shown in Figure 8.

This tank circuit is used because of the fact that a high feedback amount and stable oscillation are obtained as a result of the frequency characteristics of the capacitance C7 and inductor L9; however, in order to avoid the occurrence of abnormalities such as self-excited oscillation, etc. caused by an excessively high Q (frequency selection characteristics) value of the tank circuit, Q is lowered by inserting a resistance R4 (constituting a damping resistance) in parallel.

Figure 10 is a circuit diagram which illustrates an embodiment of the laser beam generating circuit of the present invention in which the inductors L5 through L8 and tank circuit in Figure 9 are replaced by ferrite beads FB1 through FB5.

As also described in the embodiment shown in Figure 6, it is desirable to use ferrite beads as inductors. The reason for this is that ferrite beads have such characteristics that they show a high impedance and a high pure resistance value at a specified frequency.

With the use of ferrite beads, the characteristics required in the tank circuit in Figure 9 can be obtained by a single ferrite bead; and also since the radiation of electromagnetic waves is sealed inside such beads, the effect on the oscillating circuit can be reduced. Thus, the oscillation can be stabilized.

As a result of the use of such ferrite beads, the size of the circuit can be reduced, costs can be reduced, and the oscillation can be stabilized.

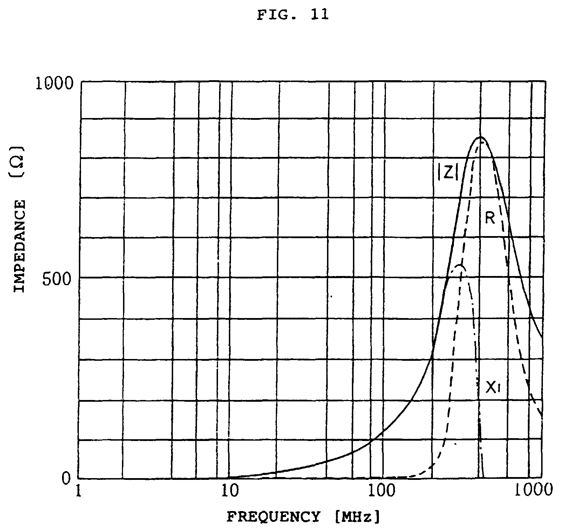

Figure 11 is a graph that shows typical characteristics of ferrite beads.

It may be seen from Figure 11 that ferrite beads have such characteristics that they show a high impedance and a high pure resistance value at a specified frequency.

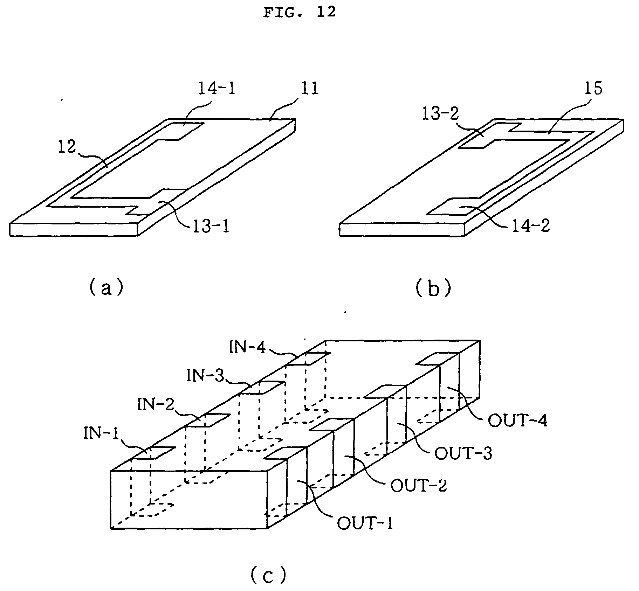

Figures 12(a) through 12(c) are perspective views which show the structure of a ferrite bead array, and a completed block.

Figure 12(a) is a perspective view of the first layer, Figure 12(b) is a perspective view of the second layer, and Figure 12(c) is a perspective view of a ferrite bead array (hereafter referred to as "FBA") accommodating four coils constructed by alternately laminating the layers shown in Figures 12(a) and 12(b).

The method used to form the FBA shown in Figure 12(c) is as follows: i. e., the surface of a first rectangular ferrite material sheet (hereafter referred to as a "green sheet") 11 shown in Figure 12(a) is coated with a conductive material 12 in a semi-rectangular pattern running along the inside of two sides forming a right angle of the rectangular shape of the green sheet, and an initial terminal 13-1 and final terminal 14-1 respectively constituting pad parts in which the area of the conductive material is increased are formed in the initial end portion and final end portion of the conductor consisting of the conductive material 12. Next, on the surface of the second green sheet, a conductor formed by applying a conductive material 15 is formed in a more or less point-symmetrical pattern with respect to the conductive material 12 on the surface of the above-described first green sheet, with the center of the green sheet as the axis of rotation, and an initial terminal 13-2 and final terminal 14-2 constituting pad parts are formed in the initial end portion and final end portion of the conductor in the same manner as in the case of the first green sheet. Then, green sheets alternately coated with semi-rectangular conductor patterns in the same manner are laminated.

In the above-described laminated green sheets, the initial terminal 13-1 of the first green sheet is used as an input terminal, and electrical continuity is obtained between the final terminal 14-1 of the first green sheet and the initial terminal 13-2 of the second green sheet by forming a through-hole. Likewise, the final terminal 14-2 of the second green sheet and the initial terminal (not shown) of a third green sheet are also connected by means of a through-hole. Then, by repeating this operation, the final terminal of the final green sheet is used as an output terminal.

By connecting the initial terminals and final terminals of the conductors formed on the respective green sheets by means of through-holes as described above, a coil is formed which is electrically continuous from the input terminal of the first green sheet to the output terminal of the final green sheet.

The FBA shown in Figure 12(c) is obtained so that four coils formed by the method described above are lined up and formed into a block in a direction that is substantially perpendicular to the direction in which the input terminals and output terminals are connected. Thus, independent inductances are formed for each combination of input and output terminals.

By using FBAs of the type shown in Figure 12(c) as FB2 through FB5 in Figure 10, it is possible to prevent the diffusion of the fundamental wave and higher harmonic components into external circuits in the DC power supply Vcc, semiconductor laser driving power source LDD, photo-detection (PD) circuit used to check the amount of beam emitted by the semiconductor laser, and ground (GND) circuit.

In the meantime, when such a ferrite bead array FBA is used in each of the above-described Vcc, LDD, PD and GND circuits, the phase of the power supply Vcc, line which is connected to the collector of the transistor TR1 and the phase of the semiconductor laser driving power supply line LDD which is connected to the emitter of the transistor TR1 are mutually inverted phases. Accordingly, by using a structure in which the inductances used to prevent unnecessary radiation are installed in close proximity to each other inside the FBA, the unnecessary radiation components are reduced as a result of being mutually canceled by crosstalk. As a result, it would appear that the diffusion of the above-described fundamental wave and higher harmonic components into external circuits can be prevented.

In the above, a laser beam generating circuit construction in which unnecessary radiation is reduced by using inductances so as to isolate the ground line of the laser beam generating circuit from the ground line, and a construction in which a ferrite bead array is used as such inductances, are described. Next, a laser beam generating circuit which can reduce unnecessary radiation without using inductances will be described.

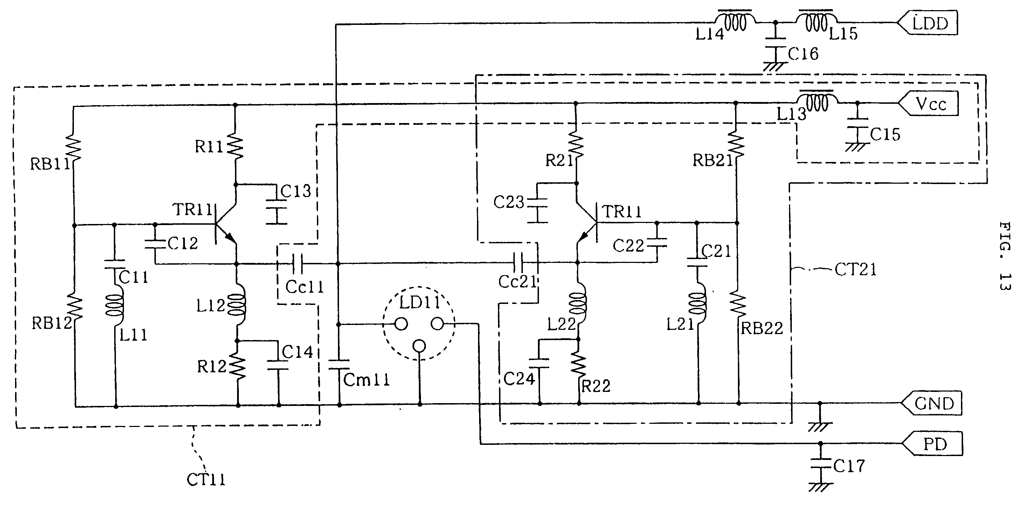

Figure 13 is a circuit diagram which illustrates one embodiment of such a laser beam generating circuit of the present invention.

The laser beam generating circuit shown in Figure 13 comprises a first high-frequency oscillating circuit CT11 surrounded by a broken line, a second high-frequency oscillating circuit CT21 surrounded by a one-dot chain line, and the remaining semiconductor laser circuit.

The first and second high-frequency oscillating circuits CT11 and CT21 are so-called Colpitts type oscillators that use current feedback bias circuits. Series circuits consisting of base bleeder resistances RB11, RB12 and RB21, RB22 are connected between the DC power supply Vcc and ground. A voltage is supplied to the bases of transistors TR11 and TR21 from intermediate points in these series circuits, and a DC voltage is applied to the collectors of TR11 and TR21 from Vcc via resistances R11 and R21.

Furthermore, series circuits consisting of inductances L11 and L21 and capacitances C11 and C21, which are the main elements determining the oscillation frequency, are connected between the bases of the transistors TR11 and TR21 and ground; and capacitances C12 and C22 are connected in parallel between the bases and emitters.

In addition, series circuits consisting of inductances L12 and L22 and parallel circuits of emitter resistances R12 and R22 and emitter capacitances C14 and C24, are connected between the emitters of the transistors TR11 and TR21 and ground, and an oscillating output current is extracted from the emitters of the transistors TR11 and TR21 via the capacitances Cc11 and Cc21. This high-frequency signal is superimposed on the direct current from the semiconductor laser driving power source LDD, so that the semiconductor laser LD11 is driven.

Furthermore, a low-pass filter constructed from an inductance L13 and a capacitance C15 is inserted into the DC power supply Vcc, and by-path condenser C13 and C23 are connected between the collectors of the transistors TR11 and TR21 and ground.

The low-pass filter and inductances inserted into the DC power supply Vcc and semiconductor driving power source LDD are to prevent the higher harmonic components generated in the laser beam generating circuit from leaking into other external circuit blocks via the power supply line and other lines.

Furthermore, the output of the photo-detection (PD) terminal used to check the amount of beam emitted by the semiconductor laser LD11 is connected to an external control part, and the amount of beam emitted by the semiconductor laser is controlled.

The high-frequency oscillating circuit CT11 shown in Figure 13 depends on the values of the elements constituting the oscillating loop, the inductance L11, the capacitance C11, the capacitance C12, the inductance L12, the capacitance C14, the coupling capacitance Cc11 and the matching capacitance Cm11. Furthermore, the high-frequency oscillating circuit CT21 depends on the values of the elements constituting the oscillating loop, the inductance L21, the capacitance C21, the capacitance C22, the inductance L22, the capacitance C24, the coupling capacitance Cc21 and the matching capacitance Cm11. The oscillating frequency can be changed by varying these element values; in particular, the element values of the series circuit consisting of the inductance L11 and capacitance C11, and the element values of the series circuit consisting of the inductance L21 and capacitance C21, are the governing factors in this case.

Meanwhile, the semiconductor laser LD11 has a low impedance in electrical terms and shows the characteristics of an inductance in equivalent terms. Accordingly, the capacitance Cm11 and inductance L12 are connected in parallel with the semiconductor laser LD11 so as to cause parallel resonance with the laser LD11. Thus, such a circuit construction is employed that parallel resonance including the capacitance Cc11 and capacitance C14 is effected, thereby causing the output current of the high-frequency oscillating circuit CT11 to be supplied to the semiconductor laser LD11 at a maximum level.

Similarly, the capacitance Cm11 and inductance L22 are connected in parallel with the semiconductor laser LD11, thus causing parallel resonance of the semiconductor laser LD11 including the capacitance Cc21 and capacitance C24, so that the output current of the high-frequency oscillating circuit CT21 is supplied to the semiconductor laser LD11 at a maximum level.

Furthermore, the low-pass filter consisting of the inductance L13 and capacitance C15 inserted into the DC power supply Vcc and the low-pass filter constructed from the inductance L14, inductance L15 and capacitance C16 inserted into the laser driving power source LDD are used to prevent higher harmonic components generated by the high-frequency oscillating circuits CT11 and CT21 from leaking into other circuit blocks via the power supply line.

Thus, the high-frequency oscillating circuits CT11 and CT21 generate high-frequency currents of two or more frequencies, and the semiconductor laser LD11 is driven by superimposing these high-frequency currents on the direct current; as a result, unnecessary radiation can be reduced.

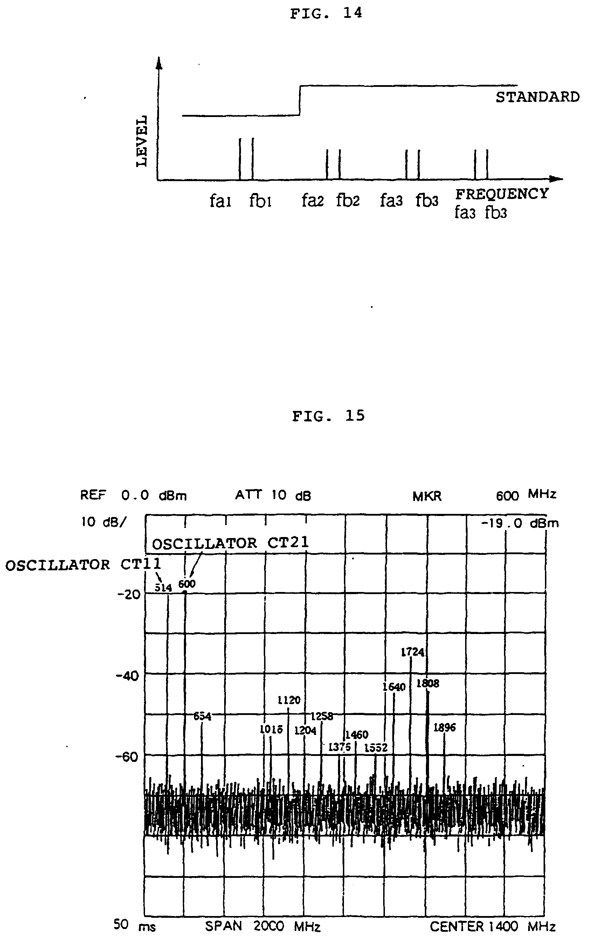

Figure 14 is a diagram which shows, in model form, the relationship between frequency spectrum data for the fundamental wave and higher harmonics in one embodiment of the laser beam generate circuit of the present invention and a standard for unnecessary radiation.

Figure 14 shows a case in which the fundamental wave components of the output components of two laser beam generating circuits A and B as shown in Figure 13 are respectively designated as fa1 and fb1, the higher harmonic components are designated as fa2, fb2, ... fa4, fb4 and so on, and these components are applied to a semiconductor laser LD. By way of this, the same superimposition effect can be obtained even if the respective fundamental wave components and higher harmonic components are suppressed to a low output level compared to a case in which the semiconductor laser is driven by a power supply with a single superimposed high frequency. As a result, the level of unnecessary radiation can he conspicuously reduced by keeping the output levels of the respective high-frequency oscillators used for superimposition at low levels.

Figure 15 is a diagram which shows the frequency spectrum of one embodiment of the laser beam generating circuit of the present invention.

The values of the elements constituting the high-frequency oscillators CT11 and CT21 in this case are, as the element values of the high-frequency oscillating circuits CT11 and CT21: RB11 (RB21) = 2.2 kS, RB12 (RB22) = 1 kS, R11 (R21) =30 S, L11 (L21) = 15 mH, C11 (C21) = 12 pF, L12 (L22) = 39 mH, R12 (R22) = 33 S, C14 (C24) = 33 pF, Cc11 (Cc21) = 2 pF, C13 (C23) = 330 pF, L13 = L14 = L15 =27 mH, C15 = C16 = 330 pF, and Cm11 = 13 pF.

The oscillation frequency of the high-frequency oscillator CT11 is set at 520 MHz, and the output is set at 10.3 dBm. The oscillating frequency of the high-frequency oscillator CT21 is set at 600 MHz by finely adjusting the above-described element values, and the output is set at 10.3 dBm.

Figure 15 shows the frequency spectrum in a case where the high-frequency currents of the above-described two frequencies were superimposed on the direct current and applied to the semiconductor laser, thus causing a beam emission of 3 mW. It is seen that the level of the fundamental wave of the high-frequency oscillator CT21 is -19.0 dBm, and that the high-frequency oscillator CT11 is suppressed to -21.0 dBm.

Furthermore, it is seen that even the largest higher harmonic component is suppressed to a small value, i. e., -33.0 dBm at 1724 MHz.

In regard to the high-frequency oscillators used for superimposition in the present invention, it is confirmed that, as long as a high frequency is generated, the same effect may be obtained using LC oscillators, RC oscillators or piezo-electric oscillators such as quartz oscillators or ceramic oscillators, etc.

Though two different frequencies are used in the embodiment above, it would also be possible to use more than two different frequencies.

Next, the method for adjusting the above-described laser generating circuit will be described.

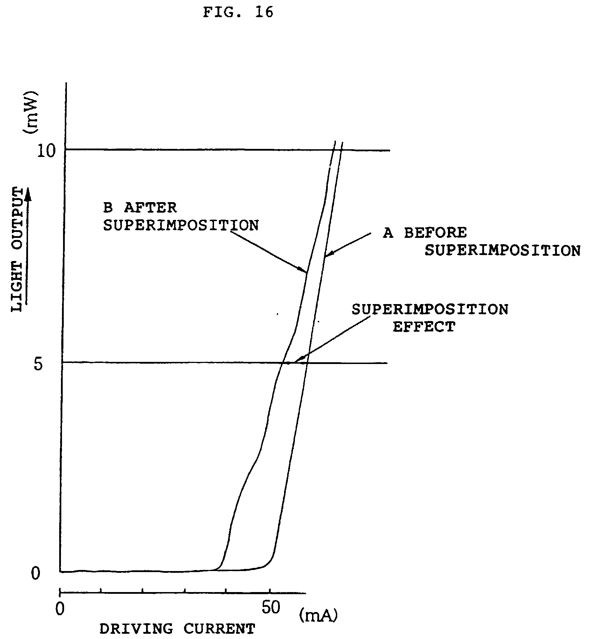

Figure 16 illustrates the superimposition effect from the relationship between the driving current of the laser beam generating circuit and the beam output of the semiconductor laser.

In Figure 16, the driving current (units: mA) is shown on the horizontal axis, and the beam output (units: mW) is shown in the vertical axis. The beam output in a case where the semiconductor laser LD is driven only by a direct current is indicated by curve A (A before superimposition), while the beam output in a case where the semiconductor laser LD is driven with a high-frequency current superimposed on the above-described direct current is indicated by curve B (B after superimposition).

In Figure 16, if for example, curve A and curve B in a case where the beam output is 5 mW are compared, it is seen that a smaller driving current is required in the case of curve B, in which a high-frequency current is superimposed. This is referred to as the "superimposition effect", and the difference between curve A and curve B in terms of the driving current required in order to obtain the same beam output is referred to as the "degree of modulation".

It is universally known that when a high-frequency current is superimposed on the direct current that drives the semiconductor laser LD, not only the fundamental wave component but also the higher harmonic components, contribute greatly to the suppression of fluctuations in the beam output.

Meanwhile, in the above-described standard for unnecessary radiation, such radiation is regulated by the level values (peak values) of various frequency components, and values exceeding the standard are prohibited at all frequencies. The relationship between the frequency components of the high-frequency oscillator(s) used for superimposition and the standard for unnecessary radiation is as shown in model form in Figure 5. As shown in Figure 5, the above-described superimposition effect is obtained as a result of the presence of the fundamental wave component (f1), and the second (f2), third (f3) and further higher harmonic components.

The effect whereby the beam output value of the semiconductor laser LD1 in Figures 2 and 3 is stabilized by the superimposition of the high-frequency current Iac on the direct current Idc that drives the semiconductor laser LD1 is further increased by the presence of the higher harmonic components f2 through f4, etc., in addition to the fundamental wave component f1 of the output of the high-frequency oscillating circuit CT1.

Here, in the embodiments shown in Figure 6 and Figures 8 through 10, the output of the high-frequency oscillating circuit CT1 is connected to the semiconductor laser circuit CT2 via the coupling capacitance Cc1, and the matching capacitance Cm is connected in parallel between the LD terminal of the semiconductor laser LD1 and ground (GND). Furthermore, a driving current is supplied to the semiconductor laser LD1 from the semiconductor laser LD driving power source LDD via a low-pass filter or inductor.

For example, the process by which impedance matching between the high-frequency oscillating circuit CT1 and the semiconductor laser LD1 is achieved will be described using Figure 10.

In the past, it was considered that the superimposition effect increases with an increase in the output level of the high-frequency oscillating circuit CT1. Therefore, the output of the high-frequency oscillating circuit CT1 used alone has been adjusted (while being observed by means of a measuring device with a 50 Ω terminal impedance, e. g., a spectrum analyzer) so that the maximum output is obtained.

Conventionally, the superimposition effect is measured by connecting the high-frequency oscillating circuit CT1 to the semiconductor laser LD1 via the coupling capacitance Cc1 and then measuring the beam output of the semiconductor laser LD1. In cases where the superimposition effect (amount of superimposition) does not show the maximum value or desired value, the value of the matching capacitance Cm1 is adjusted by trial-and-error, i. e., by repeating a process in which the matching capacitance Cm1 is replaced, and then the amount of superimposition is again measured.

Accordingly, so as to improve the method used to adjust this matching capacitance Cm1, various experiments were performed in order to elucidate the relationship of the frequency of the high-frequency oscillating circuit CT1, the mode of the semiconductor laser LD1, and the matching capacitance Cm1.

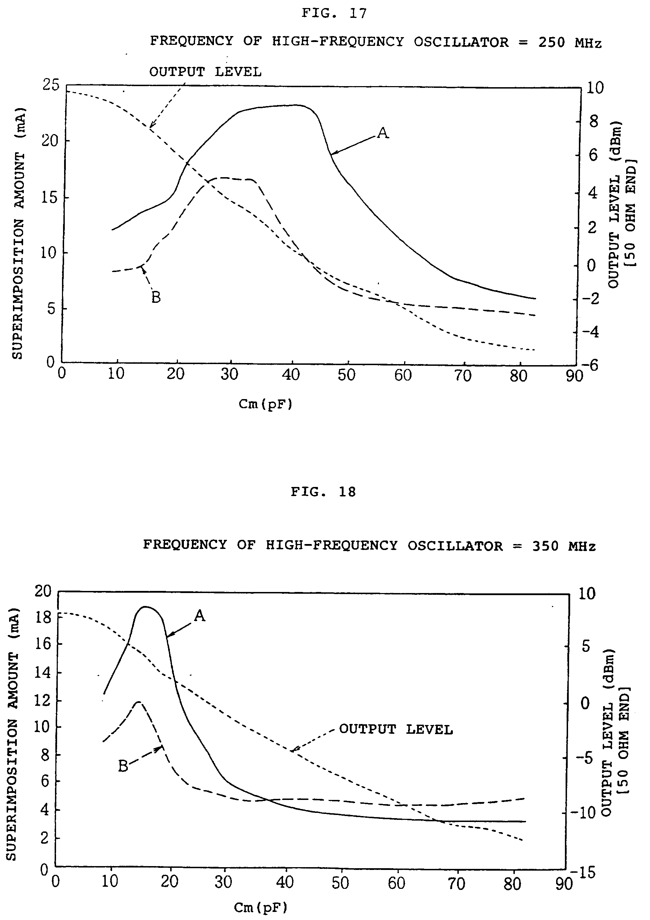

Figure 17 is a graph which illustrates the relationship of the semiconductor laser mode, frequency of the superimposed current and matching capacitance in a case where the high-frequency oscillation frequency is 250 MHz.

Figure 17 shows the results obtained when the relationship of the matching capacitance Cm1 (pF), amount of superimposition (mA) and output level (dBm) of the high-frequency oscillator at a 50 Ω terminal impedance was measured using two types of semiconductor lasers A and B with the oscillation frequency of the high-frequency oscillating circuit CT1 being set at 250 MHz. It is seen that the matching capacitance Cm1 which shows the maximum value of the superimposition effect (amount of superimposition) varies according to the type of semiconductor laser used, and that there is no relationship between the maximum value of the output level of the high-frequency oscillating circuit CT1 and the maximum value of the amount of superimposition.

Figure 18 is a graph which illustrates the relationship of the semiconductor laser mode, frequency of the superimposed current and matching capacitance in a case where the high-frequency oscillation frequency is 350 MHz.

Figure 18 shows the results obtained when the relationship of the amount of superimposition, the output level at a 50 Ω terminal impedance and the matching capacitance Cm1 was measured using the same types of semiconductor lasers A and B as in Figure 17 with the frequency of the high-frequency oscillating circuit CT1 set at 350 MHz. Here, it is seen that even in cases where the same type of semiconductor laser is used, the value of the matching capacitance Cm1 which shows the maximum amount of superimposition varies according to the frequency of the high-frequency current that is superimposed on the direct current used to drive the semiconductor laser LD.

It is seen from the above experimental results that the maximum value of the superimposition effect in a semiconductor laser depends on the mode of the semiconductor laser and the frequency of the high-frequency current that is superimposed.

Accordingly, if data is acquired beforehand for the amount of superimposition by varying the matching capacitance Cm for various combinations of semiconductor laser modes and superimposition oscillator frequencies, and the requirements in terms of the mode of the semiconductor laser used in the laser beam generating circuit and the frequency of the high-frequency current used for superimposition are decided, the matching capacitance can be definitively determined.

Furthermore, the amount of superimposition required is not always the maximum value; and there may be cases in which a value that is far apart from the maximum value is designated. In the case of such requirements as well, the matching capacitance can easily be determined if data for the laser mode, frequency of the high-frequency oscillator used for superimposition and matching capacitance Cm are prepared beforehand.

In a laser beam generating circuit that is comprised of a semiconductor laser, a high-frequency oscillator, a coupling capacitance, a matching capacitance and a power supply, the matching capacitance at which the superimposition effect shows a maximum value can be obtained on the basis of data acquired beforehand by varying the matching capacitance for various combinations of the semiconductor laser and frequency of the high-frequency oscillator and measuring the amount of superimposition of the high frequency; then, the matching capacitance can be adjusted so that the prescribed amount of superimposition is obtained.

As shown in each of the embodiments described above, the invention of the present application possesses the following superior merits: i. e., in a beam pick-up device which is used to write information on a high-density memory data recording medium (optical disk) using laser beam or to read out information which has thus been written, the high-frequency oscillator side and the control device side can be separated from each other in high-frequency terms by inserting devices such as inductors, etc. which show a high impedance at high frequencies between the ground line of the high-frequency circuit and the ground line of the overall device. As a result, the need for a so-called shielding case such as a metal case, etc., which has conventionally been necessary between the high-frequency oscillator and the control device, can be eliminated. Therefore, the size of the device can be reduced, a pick-up construction which is superior in terms of mobility can be obtained, and the cost of the device can be reduced.

Furthermore, in the DC power supply path, the DC laser driving current supply path and the path used to check the amount of emitted beam as well, it is possible to separate the high-frequency oscillator side and the control device side from each other in terms of high-frequency by inserting devices such as inductors, etc., which show a high impedance at high frequencies in the same manner as in the case of the above-described ground lines. Accordingly, a pick-up construction which is superior in terms of compactness and mobility can be obtained, and costs can be reduced, in the same manner as described above.

In addition, by using ferrite beads as the above-described "devices such as inductors, etc.", a further reduction in circuit size, reduction in cost, etc. can be accomplished. Moreover, with ferrite beads used in a plurality of the paths referred to above in the form of ferrite head arrays, an additional effect of mutual cancellation of unnecessary radiation of different phases can be obtained.

Furthermore, in cases where devices such as inductors, etc. which show a high impedance at high frequencies are inserted into the signal feedback path of the high-frequency oscillating circuit, the oscillation can be stabilized; and moreover, in cases where the "devices such as inductors, etc." are ferrite beads, the size of the circuit can be reduced, and a reduction in cost can be achieved.

Furthermore, the present invention is constructed so that the semiconductor laser is driven with two different high-frequency currents superimposed on the DC laser driving current, either by means of a high-frequency oscillating circuit which is capable of generating two fundamental waves or by means of a high-frequency oscillating circuit which is capable of utilizing the fundamental wave and the higher harmonics of the fundamental wave; accordingly, it is possible to obtain a sufficient superimposition effect even if the levels of the fundamental waves or higher harmonics from the high-frequency oscillating circuit are kept at low levels. Accordingly, unnecessary radiation from the high-frequency oscillating circuit can he conspicuously reduced.

## Claims

**1.** A laser beam generating circuit that uses a semiconductor laser device characterized in that said laser beam generating circuit comprises:
at least one high-frequency oscillating circuit which receives power from a DC power supply and generates a high-frequency current,
a semiconductor laser device having a ground terminal, said semiconductor laser device receiving a DC laser driving current from a laser driving current source so as to generate and emit laser beam and further receiving reflected beam of said laser beam so as to perform a confirmational output of an amount of beam emitted,
a coupling capacitance provided between said high-frequency oscillating circuit and semiconductor laser device so as to couple said high-frequency oscillating circuit and semiconductor laser device, thus superimposing said high-frequency current on said DC laser driving current, and
a matching capacitance provided between an input terminal of said DC laser driving current and a ground terminal so as to perform impedance matching on said high-frequency current,
wherein an inductance element which has a high impedance at an oscillation frequency of said high-frequency oscillating circuit is provided in at least a path from said ground terminal to a ground part of an other internal circuit which controls said laser beam generating circuit, so that said ground terminal and internal circuit are connected via said inductance element.

**2.** A laser beam generating device that uses a semiconductor laser device according to Claim 1, characterized in that a circuit which has a high impedance with respect to a prescribed frequency is provided in a signal feedback path of said high-frequency oscillating circuit.

**3.** A laser beam generating device that uses a semiconductor laser device according to Claim 2, characterized in that said circuit which has said high impedance is comprised of ferrite beads.

**4.** A laser beam generating circuit that uses a semiconductor laser device according to Claim 1, characterized in that said ground terminal is electrically connected via a ground capacitance from a point on a DC power supply path of said high-frequency oscillating circuit, a point on said DC laser driving current path, and a point on a path of said confirmational output of said amount of beam emitted.

**5.** A laser beam generating device that uses a semiconductor laser device characterized in that in a laser beam generating circuit which comprises at least a DC power supply terminal, a semiconductor laser driving power supply terminal, a terminal for checking an amount of beam emitted by a semiconductor laser, a ground terminal, and a high-frequency oscillating circuit; an inductance element which has a high impedance at an oscillation frequency of said high-frequency oscillating circuit is provided in said ground terminal, so that said ground terminal and an internal circuit are connected via said inductance element.

**6.** A laser beam generating device that uses a semiconductor laser device according to Claim 5, characterized in that said inductance element which has said high impedance is an inductance element comprising ferrite beads.

**7.** A laser beam generating device that uses a semiconductor laser device according to Claim 4, characterized in that a circuit which has a high impedance with respect to a prescribed frequency is provided in a signal feedback path of said high-frequency oscillating circuit.

**8.** A laser beam generating device that uses a semiconductor laser device according to Claim 7, characterized in that said circuit which has said high impedance is comprised of ferrite beads.

**9.** A laser beam generating device that uses a semiconductor laser device characterized in that in a laser beam generating circuit which comprises at least a high-frequency oscillating circuit and constructed so that an output of said high-frequency oscillating circuit is superimposed on a semiconductor laser driving power supply, said high-frequency oscillating circuit is equipped with a circuit which is installed in a path of a signal feedback circuit and has a high impedance with respect to a prescribed frequency, and said circuit which has said high impedance is an inductance element using ferrite beads.

**10.** A laser beam generating device that uses a semiconductor laser device according to Claim 1, characterized in that said inductance element is provided in a DC power supply path of said high-frequency oscillating circuit, in said DC laser driving current path and in said beam emission confirmational output path, in addition to being provided in a path from said ground terminal to said ground part of another internal circuit which controls said laser beam generating circuit.

**12.** A laser beam generating device that uses a semiconductor laser device according to Claim 11, characterized in that said inductance elements are constructed using ferrite beads.

**13.** A laser beam generating device that uses a semiconductor laser device according to Claim 12, characterized in that said inductance elements are constructed using ferrite bead arrays in which a plurality of ferrite beads are formed into a integral unit.

**14.** A laser beam generating device that uses a semiconductor laser device characterized in that in a laser beam generating circuit which comprises at least a DC power supply terminal, a semiconductor laser driving power supply terminal, a terminal for checking an amount of beam emitted by a semiconductor laser, a ground terminal, and a high-frequency oscillating circuit; ferrite bead arrays in which a plurality of inductance elements comprising ferrite beads are armed into an integral unit are provided in said DC power supply terminal, in said semiconductor laser driving power supply terminal, in said terminal for checking an amount of beam emitted by a semiconductor laser, and in said ground terminal, so that respective terminals and internal circuitry are connected via said inductance elements.

**15.** A laser beam generating device that uses a semiconductor laser device according to Claim 10, characterized in that a circuit which has a high impedance with respect to a prescribed frequency is provided in a signal feedback path of said high-frequency oscillating circuit.

**16.** A laser beam generating device that uses a semiconductor laser device according to Claim 15, characterized in that said circuit which has said high impedance is comprised of ferrite beads.

**17.** A laser beam generating device that uses a semiconductor laser device characterized in that in a laser beam generating circuit which comprises:
at least one high-frequency oscillating circuit which receives power from a DC power supply and generates a high-frequency current,
a semiconductor laser device having a ground terminal, said semiconductor laser device receiving a DC laser driving current from a laser driving current source so as to generate and emit laser beam and further receiving reflected beam of said laser beam so as to perform a confirmational output of an amount of beam emitted,
a coupling capacitance provided between said high-frequency oscillating circuit and semiconductor laser device so as to couple said high-frequency oscillating circuit and semiconductor laser device, thus superimposing said high-frequency current on said DC laser driving current, and
a matching capacitance provided between an input terminal of said DC laser driving current and a ground terminal so as to perform impedance matching on said high-frequency current;
a higher-harmonic current output of said high-frequency oscillating circuit is an output in which at least one type of higher harmonic output is superimposed on a fundamental wave output of an oscillation frequency.

**18.** A laser beam generating device that uses a semiconductor laser device characterized in that in a laser beam generating circuit which comprises:
at least one high-frequency oscillating circuit which receives power from a DC power supply and generates a high-frequency current,
a semiconductor laser device having a ground terminal, said semiconductor laser device receiving a DC laser driving current from a laser driving current source so as to generate and emit laser beam and further receiving reflected beam of said laser beam so as to perform a confirmational output of an amount of beam emitted,
a coupling capacitance provided between said high-frequency oscillating circuit and semiconductor laser device so as to couple said high-frequency oscillating circuit and semiconductor laser device, thus superimposing said high-frequency current on said DC laser driving current, and
a matching capacitance provided between an input terminal of said DC laser driving current and a ground terminal so as to perform impedance matching on said high-frequency current; wherein
said high-frequency oscillating circuit is comprised of a plurality of high-frequency oscillating circuits, and fundamental wave outputs of a plurality of oscillation frequencies are superimposed on said DC laser driving current as a higher harmonic current output.

**19.** A laser beam generating device that uses a semiconductor laser device according to Claim 18, characterized in that said high-frequency current output of said high-frequency oscillating circuit is an output in which at least one type of higher harmonic output of respective fundamental wave outputs of said plurality of oscillation frequencies is superimposed.

**20.** A laser beam generating device that uses a semiconductor laser device characterized in that said laser beam generating device comprises at least a high-frequency oscillating circuit and constructed so that an output of said high-frequency oscillating circuit is superimposed on a semiconductor laser driving power supply, wherein said high-frequency oscillating circuit generates two or more oscillation frequency signals and is constructed so that said plurality of high-frequency signals are superimposed on said semiconductor laser driving power supply.

**21.** A laser beam generating device that uses a semiconductor laser device according to Claim 20, characterized in that said high-frequency oscillating circuit is comprised of a plurality of high-frequency oscillators.
